# DEMANDE DE BREVET EUROPEEN

(11) **EP 0 924 685 A1**
(43) Date de publication de la demande: **23.06.1999**
(21) Numéro de dépôt: 98402770.6
(22) Date de dépôt: 09.11.1998
(51) Int. Cl.: G09G 5/24

(54) **Procédé de stockage d'informations de formats différents dans une mémoire et dispositif de stockage et de lecture correspondant**

(30) Priorité: 24.11.1997 FR 9714727
(71) Demandeur: STMicroelectronics SA, 94250 Gentilly Cedex (FR)
(72) Inventeur: Tournier, Christian, 38170 Seyssient-Pariset (FR); Lusinchi, Laurent, 38120 Saint-Egrève (FR)
(74) Mandataire: Casalonga, Axel

(57) **Abrégé**

On adresse la mémoire (MM) avec, selon le format, des mots d'adresses (MDC) formés au moins à partir des bits de poids forts de l'identifiant (ID) de chaque information, et éventuellement complétés par des mots de contrôle ou de sélection (MS) permettant soit de désigner des adresses consécutives soit de sélectionner dans chaque cellule-mémoire (CM) des parties de celles-ci en fonction des bits de poids faibles de l'identifiant. Ceci permet un adressage continu de la mémoire quel que soit le format utilisé, ce qui optimise la taille mémoire et évite une modification structurelle ou logicielle du système d'adressage à chaque changement de format.

Application à la télévision.

## Description

L'invention concerne le stockage et la lecture d'informations de formats différents dans une mémoire.

L'invention s'applique avantageusement mais non limitativement au domaine de la télévision, et plus particulièrement au stockage et à la lecture de caractères de formats différents dans une mémoire morte destinée à être lue par le contrôleur d'écran pour l'affichage sur ce dernier des caractères ainsi lus.

Chaque caractère est généralement représenté sur un certain nombre de bits, par exemple 9x13 correspondant à une matrice de 9x13 pixels.

Le format de représentation des caractères peut être normalisé, par exemple dans le cas sous-titrage, ou bien peut être libre notamment en ce qui concerne des caractères spécifiquement dédiés au téléviseur, par exemple des caractères dits "de menu" qui permettent notamment l'apparition à l'écran de symboles tel qu'un haut-parleur barré pour indiquer que le son du téléviseur a été coupé.

Par ailleurs, si les caractères de format 9x13 sont par exemple utilisés aux Etats-Unis, certains pays qui utilisent un alphabet non latin, requièrent des formats de caractères différents, par exemple un format 18x26.

Généralement, pour une application donnée, un même format de caractère est requis, par exemple un format 9x13, ou un format 18x26. 0r, actuellement, la conception et la réalisation d'un système de stockage et de lecture de caractères dans un format donné, sont spécifiques du format et un tel système nécessite d'être entièrement réétudié, notamment au niveau de l'adressage de la mémoire de stockage des caractères, pour un format différent de caractères.

L'invention vise à apporter une solution à ce problème.

Un but de l'invention est de proposer un dispositif de stockage et de lecture d'informations de formats différents dont l'architecture matérielle et logicielle, notamment au niveau de l'adressage de la mémoire, soit identique pour ces formats différents d'informations par exemple un format 9x13 et un format 18x26.

L'invention a encore pour but de proposer un tel dispositif dans lequel la taille de la mémoire de stockage soit optimisée et puisse être réduite ou augmentée en fonction du nombre de caractères à stocker quel que soit le format utilisé, et sans que cela nécessite des modifications importantes dans la structure des moyens d'adressage.

L'invention a également pour but de pouvoir stocker dans la mémoire de stockage uniquement des caractères d'un premier format (par exemple 9x13) ou bien uniquement des caractères d'un deuxième format (par exemple 18x26) ou encore des caractères d'un premier format et des caractères d'un deuxième format, et ce, tout en conservant la même structure d'adressage.

L'invention propose donc un procédé de stockage d'informations de formats différents dans une mémoire, ces informations, par exemple des caractères alphanumériques, comportant des premières informations d'un premier format (par exemple 9x13) représentées chacune sur un premier nombre de bits (9x13) et identifiées chacune par un premier identifiant codé sur p+n+e bits (par exemple 11 bits), p (par exemple 8) et n (par exemple 2) étant des entiers strictement positifs et e (par exemple 1) étant un entier positif ou nul. Les e bits éventuels sont avantageusement des bits d'extension d'adressage permettant d'augmenter de façon flexible le nombre de caractères pouvant être stockés. Les informations peuvent également comporter des deuxièmes informations d'un deuxième format représentées chacune sur un deuxième nombre de bits supérieur ou égal au produit du premier nombre par 2ⁿ et identifiées chacune par un deuxième identifiant codé sur p+e bits. Dans le cas d'un deuxième format égal par exemple à 18x26, le deuxième nombre de bits sera égal au produit du premier nombre (9x13) par 2².

La mémoire comporte des cellules-mémoires pouvant, selon la structure de la mémoire, contenir chacune 2^{k} ensembles de bits, le nombre de bits de chaque ensemble de bits étant au moins égal audit premier nombre (en l'espèce 9x13). k est ici un entier supérieur ou égal à 0 et inférieur ou égal à n et chaque cellule-mémoire peut être désignée par un mot d'adresse-cellule de p+n-k+e bits.

Ainsi, selon une première caractéristique de l'invention, chaque deuxième information est décomposée en vue de son stockage en 2ⁿ ensembles de bits répartis sur une ou plusieurs cellules-mémoire selon la structure de la mémoire, c'est-à-dire selon la valeur de k. Si le deuxième format considéré est tel que le deuxième nombre de bits (par exemple 18x26) représentant chaque deuxième information soit exactement égal au produit du premier nombre P1 de bits (9x13) par 2ⁿ (en l'espèce 2²), alors le nombre de bits de chaque ensemble de bits contenu dans une cellule-mémoire est égal au premier nombre de bits (9x13). Par contre, si le deuxième format considéré (par exemple 22x30) est tel que le deuxième nombre de bits est compris entre 2ⁿ. P1 et 2ⁿ⁺¹. P1 (en l'espèce 2².(9x13) < 22x30 < 2³(9x13)) alors le nombre de bits de chaque ensemble de bits contenu dans une cellule-mémoire est supérieur au premier nombre de bits de façon à permettre la représentation correcte et complète de chaque deuxième information.

Par ailleurs, selon le procédé selon l'invention, si k est nul, c'est-à-dire si chaque cellule-mémoire (ou mot-mémoire) ne contient qu'un seul ensemble de bits, on stocke chaque première information dans la cellule-mémoire désignée par un mot d'adresse-cellule dont les bits correspondent au p+n+e bits de l'identifiant de la première information.

Il convient de noter ici qu'au sens de la première invention, le verbe "correspondre" doit être interprété de façon très large. Plus précisément, il est particulièrement avantageux en pratique que les bits du mot d'adresse-cellule soient égaux aux bits de l'identifiant de la première information. Ceci étant, on pourrait également prévoir une table de correspondance prédéterminée entre la valeur des bits du mot d'adresse-cellule et la valeur des bits de l'identifiant.

Si k est non nul, c'est-à-dire si chaque mot mémoire ou cellule-mémoire comporte plusieurs ensemble de bits, on stocke alors chaque première information dans une partie de la cellule-mémoire désignée par un mot d'adresse-cellule dont les bits correspondent au p+n+e-k bits de poids forts de l'identifiant de la première information, cette partie de la cellule-mémoire ainsi désignée étant sélectionnée parmi les 2^{k} ensembles de bits contenus dans cette cellule-mémoire désignée, sélection effectuée à l'aide d'un mot de sélection de k bits correspondant aux k bits de poids faible de l'identifiant de cette première information.

Par ailleurs, en ce qui concerne le stockage d'une deuxième information (format 18x26 par exemple) si k est égal à n, ce qui signifie que chaque cellule-mémoire ou mot-mémoire contient 2ⁿ ensembles de bits, on stocke alors les 2ⁿ ensembles de bits formant chaque deuxième information dans la cellule-mémoire désignée par un mot d'adresse-cellule dont les e+p bits correspondent au e+p bits de l'identifiant de cette deuxième information.

Si k est différent de n, ce qui signifie que chaque deuxième information est alors répartie sur plusieurs cellules-mémoire, on stocke les 2ⁿ ensembles de bits formant chaque deuxième information dans les 2^{n-k} cellules-mémoire d'adresses consécutives désignées par 2^{n-k} mots d'adresse-cellule dont les e+p bits de poids forts correspondent aux e+p bits de l'identifiant de cette deuxième information.

Le procédé de stockage selon l'invention permet donc de stocker les informations, quel que soit leur format, de façon optimisée dans la mémoire, c'est-à-dire sans laisser de "trous" dans l'espace mémoire utilisé c'est-à-dire sans laisser de cellule-mémoire totalement inoccupée entre deux cellules-mémoire occupées. En d'autres termes, l'invention permet un stockage des informations dans des cellules-mémoire dont les adresses se succèdent de façon continue, quel que soit le format de l'information stockée. Et cette absence de discontinuité dans les adresses des cellules-mémoire utilisées persiste même si le nombre d'informations à stocker doit être réduit ou augmenté, en supprimant ou en augmentant le nombre e de bits d'extension d'adresse, ce qui permet, quel que soit le nombre d'informations à stocker d'optimiser la taille de la mémoire et d'obtenir une mémoire dont l'espace mémoire éventuellement inutilisé est dans tous les cas minimum.

L'invention propose également un dispositif de stockage et de lecture d'informations de formats différents, dans lesquels lesdites informations peuvent comporter des premières informations d'un premier format représentées chacune sur un premier nombre de bits et identifiées chacune par un premier identifiant codé sur p+n+e bits, p et n étant des entiers strictement positifs et e étant un entier positif ou nul, et/ou des deuxièmes informations d'un deuxième format représentées chacune sur un deuxième nombre de bits supérieur ou égal au produit du premier nombre par 2ⁿ et identifiées chacune par un deuxième identifiant codé sur p+e bits.

Ce dispositif selon l'invention comprend :
- une mémoire comportant des cellules-mémoire (ou mots-mémoire) aptes chacune à contenir 2^{k} ensembles de bits, et à être désignées chacune par un mot d'adresse-cellule de p+n-k+e bits, k étant un entier supérieur ou égal à zéro et inférieur ou égal à n, le nombre de bits de chaque ensemble de bits étant au moins égal audit premier nombre,
- des moyens d'adressage possédant un premier état dans lequel, pour chaque première information, ils sont aptes à élaborer, si k est nul, un mot d'adresse-cellule dont les bits correspondent aux p+n+e bits de l'identifiant de la première information et, si k est non nul, un mot d'adresse-cellule dont les bits correspondent aux p+n+e-k bits de poids forts de l'identifiant de la première information. Si k est non nul, les moyens d'adressage sont également aptes à élaborer pour chaque première information un mot de sélection de k bits correspondant aux k bits de poids faibles de l'identifiant de cette première information. Les moyens d'adressage possèdent par ailleurs un deuxième état dans lequel, pour chaque deuxième information, ils sont aptes à élaborer, si k est égal à n, un mot d'adresse-cellule dont les e+p bits correspondent aux e+p bits de l'identifiant de cette deuxième information, et, si k est différent de n, 2^{n-k} mot d'adresse-cellule dont les e+p bits de poids forts correspondent aux e+p bits de l'identifiant de cette deuxième information.

Le dispositif selon l'invention comporte par ailleurs des moyens de lecture possédant un premier état dans lequel, pour chaque mot d'adresse-cellule élaboré, ils extraient de la mémoire l'ensemble de bits stocké dans la cellule-mémoire désignée par ledit mot d'adresse-cellule, ensemble de bits éventuellement sélectionné si k est non nul, en fonction des valeurs des k bits du mot de sélection, parmi les 2^{k} ensembles de bits de ladite cellule-mémoire désignée. Les moyens de lecture possèdent par ailleurs un deuxième état dans lequel pour chaque mot d'adresse-cellule élaboré, ils extraient, si k est égal à n, les 2ⁿ ensembles de bits stockés dans la cellule-mémoire désignée par le mot d'adresse-cellule, et si k est différent de n, ils extraient les les 2ⁿ ensembles de bits stockés dans les 2^{n-k} cellules-mémoire d'adresses consécutives désignées par les 2^{n-k} mots d'adresse-cellule.

Enfin, le dispositif selon l'invention comporte des moyens de commande pour mettre les moyens d'adressage et de lecture dans leur premier ou dans leur deuxième état en fonction du format de l'information.

Ainsi, selon l'invention, l'adressage de la mémoire s'effectue avec des mots d'adresse de même taille quel que soit le format de l'information à extraire. Seul le contenu du mot d'adressage, c'est-à-dire la valeur des bits du mot d'adressage diffère en fonction du format et en fonction de l'information à extraire. Mais, ceci ne nécessite aucune modification de la structure matérielle du système d'adressage ni de la structure logicielle de ce système d'adressage.

Alors que dans certaines applications, les cellules-mémoire pourraient être de simples mots mémoire, dans une application de télévision utilisant des caractères représentés sous forme matricielle chaque première information est en fait représentée par une matrice de j lignes de i bits chacune. Ainsi, chaque cellule-mémoire comporte en fait un bloc de j paquets de i bits chacun et les moyens d'adressage élaborent alors pour chaque information j mots d'adressage-ligne à partir du mot d'adressage-cellule correspondant et d'un mot d'en-tête permettant de désigner sélectivement chacun des j paquets. Les moyens de lecture lisent alors successivement les j paquets de chaque cellule-mémoire désignée.

D'autres avantages et caractéristiques de l'invention apparaîtront à l'examen de la description détaillée de modes de réalisation et de mise en oeuvre nullement limitatifs, et des dessins annexés sur lesquels :
- la figure 1 illustre schématiquement la représentation d'un caractère d'un premier format et d'un caractère d'un deuxième format,
- la figure 2 est un synoptique très schématique d'un mode de réalisation d'un dispositif selon l'invention,
- les figures 3 et 4 illustrent respectivement deux identifiants de caractères de formats différents,
- la figure 5 illustre schématiquement la structure d'un mot d'adresse-cellule,
- la figure 6 illustre un mot d'adresse-cellule et un mot de sélection utilisé pour l'adressage d'une cellule-mémoire contenant un caractère d'un premier format,
- les figures 7a et 7b illustrent deux mots d'adresse-cellule permettant d'adresser deux cellules-mémoire contenant les différentes parties d'un caractère d'un deuxième format,
- la figure 8 illustre une autre structure possible d'un mot d'adresse-cellule,
- la figure 9 illustre schématiquement un mot d'adresse-cellule utilisable pour l'extraction d'un caractère d'un premier format en utilisant la structure de mot illustré sur la figure 8, et,
- les figures 10a à 10d illustrent schématiquement quatre mots d'adresse-cellule, utilisant la structure de la figure 8, et permettant d'extraire un caractère d'un deuxième format.

On suppose maintenant, bien que l'invention n'y soit pas limitée, que la mémoire de stockage est une mémoire morte lue par un contrôleur d'écran d'un poste de télévision et capable de stocker des caractères CA d'un premier format (9x13) et/ou des caractères CB d'un deuxième format (18x26). En d'autres termes, dans l'exemple décrit maintenant, n est égal à 2.

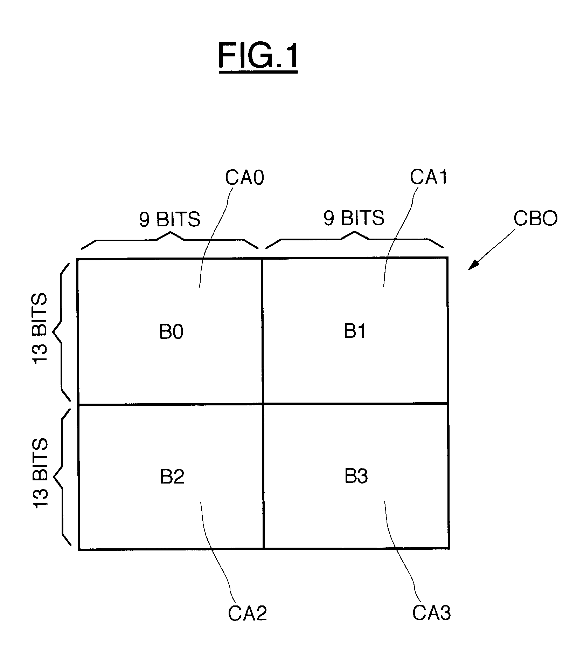

Sur la figure 1, les références B0-B3 désignent respectivement quatre ensembles de 9x13 bits permettant de représenter respectivement quatre premiers caractères CA0-CA3.

Dans l'exemple décrit ici, un caractère CB0 du deuxième format est représenté sur un deuxième nombre de bits (18x26) décomposable en 2² ensembles de 9x13 bits.

Plus précisément, ici, les ensembles B0 et B1 décrivent les lignes 1 à 13 du caractère CB0 tandis que les ensembles de bits B2 et B3 décrivent les lignes 14 à 26 de ce caractère CB0. Par ailleurs, les ensembles de bits B0 et B2 décrivent la moitié gauche du caractère CB0 et les ensembles de bits B1 et B3 décrivent la partie droite du caractère CB0.

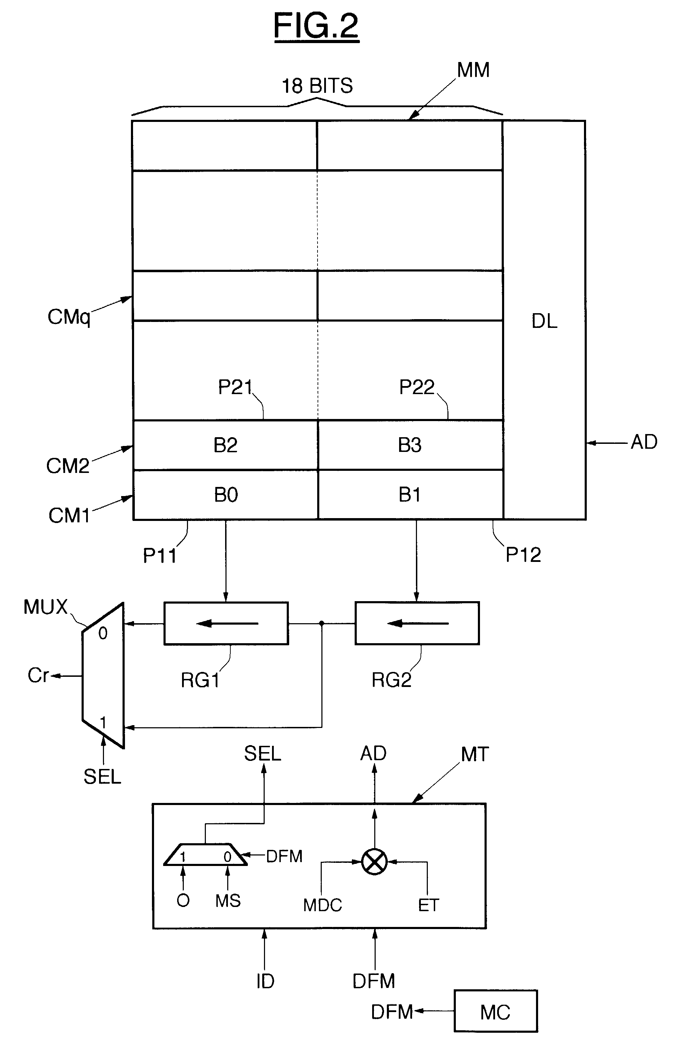

Sur la figure 2, la référence MM désigne la mémoire morte de stockage de l'ensemble des caractères destinés à être affichés sur l'écran. Cette mémoire MM est décomposée en une pluralité de cellules-mémoire CMq. On suppose par ailleurs ici que chaque cellule-mémoire CMq a une largeur de deux ensembles 9x13 bits, c'est-à-dire qu'elle est subdivisée en deux parties contenant chacune un ensemble de 9x13 bits. En d'autres termes, dans l'exemple décrit ici, k est égal à 1.

Des moyens d'adressage, incorporés dans des moyens de traitement MT sont aptes, comme on le verra plus en détail ci-après, à élaborer un mot d'adresse-ligne AD à partir d'un mot d'adresse-cellule MDC désignant chaque cellule de la mémoire MM et d'un mot d'entête ET permettant de désigner, pour chaque cellule l'un des treize paquets de 9 bits qu'elle contient. Chaque mot d'adresse MDC est élaboré à partir de l'identifiant ID d'un caractère et d'un bit de format DFM délivré par des moyens de commande MC (DFM = 0 pour 9x13 et DFM = 1 pour 18x26).

Le dispositif selon l'invention comporte par ailleurs un décodeur classique de ligne DL permettant, à partir du mot d'adresse-ligne AD, d'adresser la ligne correspondante d'une cellule, ainsi que deux registres à décalage RG1 et RG2 respectivement connectés sur le port de sortie de la mémoire MM et destinés à recevoir les bits de chacune des deux parties (par exemple P11, P12 ou P21, P22) de chaque cellule-mémoire. Ces deux registres à décalage sont reliés en série. En outre la sortie de chacun de ces registres à décalage est reliée aux deux entrées d'un multiplexeur MUX commandé par un signal de commande SEL émanant des moyens de traitement. La sortie du multiplexeur MUX délivre l'ensemble des bits Bi matérialisant soit un caractère Cr d'un premier format soit une partie d'un caractère d'un deuxième format. Plus précisément comme on le verra ci-après, selon la valeur du bit DFM, le signal SEL prendra la valeur 0 ou sera égal à un mot de sélection MS composé ici du bit (k=1) de poids faible de l'identifiant du caractère de premier format.

Le décodeur de ligne DL, les deux registres RG1 et RG2, le multiplexeur MUX, ainsi que les moyens permettant d'élaborer le signal SEL, et incorporés au sein des moyens de traitement MT, forment fonctionnellement des moyens de lecture de la mémoire MM.

Mis à part le décodeur de ligne MM, les deux registres à décalage et le multiplexeur MUX, les autres moyens du dispositif peuvent être réalisés de façon logicielle au sein d'un microprocesseur, ou bien réalisés de façon matérielle au sein d'un circuit spécifique (ASIC).

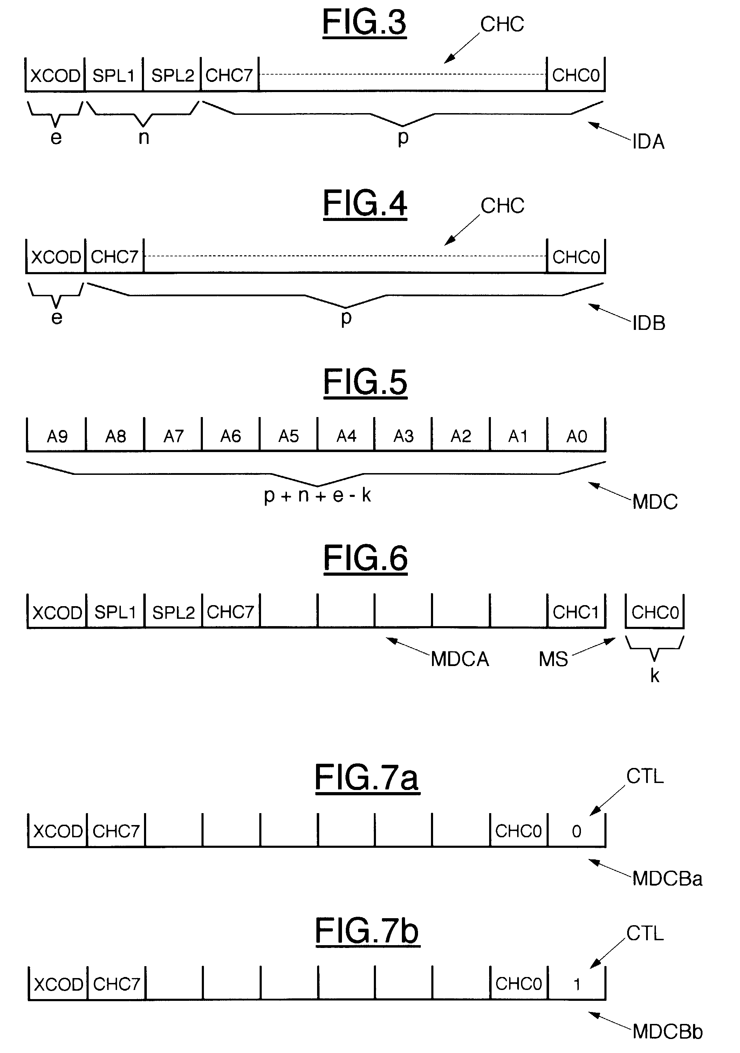

On se réfère maintenant plus particulièrement aux figures 3 à 7 pour illustrer un mode de fonctionnement du dispositif selon l'invention.

On suppose maintenant que chaque caractère CA du premier format est identifié par un identifiant IDA (figure 3) codé sur onze bits. Plus précisément, l'identifiant IDA se compose d'un mot CHC de p bits (p=8 ici) précédé de n bits SPL1, SPL2 (n=2 ici) eux-même précédés d'un bit XCOD (e=1). Généralement, les caractères destinés à un sous-titrage par exemple, sont normalisés et sont identifiés à l'aide de mot d'identification de p bits (typiquement 8 bits). Ainsi, les identifiants IDA de ces caractères normalisés auront en fait leurs bits SPL1, SPL2 et XCOD égaux à zéro. Ceci étant, l'adjonction de ces trois bits supplémentaires permet éventuellement de stocker dans la mémoire MM d'autres caractères du premier format, par exemple des caractères dits "de menu" et permettant d'afficher des symboles sur l'écran, comme par exemple un haut-parleur barré.

L'identifiant IDB de chaque caractère d'un deuxième format est composé d'un mot CHC de p bits précédé du bit XCOD. Ainsi, il est possible d'identifier 2^{p} caractères normalisés en format 18x26 utilisables par exemple pour un sous-titrage en caractère chinois. Le bit XCOD, qui est un bit d'extension d'adressage, permet de stocker éventuellement dans la matrice MM deux fois plus de caractères de formats 18x26 c'est-à-dire de stocker, en plus des caractères normalisés, d'autres caractères de menu.

Comme illustré sur la figure 5, chaque cellule-mémoire CM est désignée par un mot d'adresse-cellule MDC de p+n+e-k bits, c'est-à-dire en l'espèce dix bits, A0-A9.

Supposons maintenant que la mémoire MM ne stocke que des caractères de premier format.

Puisque chaque cellule-mémoire peut contenir deux caractères premier format, la cellule-mémoire désignée par le mot d'adresse MDCA (figure 6) va stocker les deux caractères de premier format dont les neuf bits de poids forts XCOD, SPL1, SPL2, CH7-CHC1 (c'est-à-dire tous les bits sauf le bit de poids faible CHC0) sont identiques aux bits homologues du modèle du mot d'adresse-cellule MDCA.

La partie (par exemple P11, P12) de la cellule-mémoire dans laquelle sera effectivement stocké le caractère sera sélectionnée en fonction de la valeur du bit de poids faible CHC0 de l'identifiant de ce caractère.

Ainsi, si l'on se réfère maintenant plus particulièrement à la figure 2, et dans l'hypothèse où le contrôleur de l'écran de télévision transmet un signal de lecture du caractère de premier format dont l'identifiant IDA est celui illustré sur la figure 3, les moyens d'adressage vont élaborer le mot d'adresse MDCA correspondant au neuf bits de poids forts de cet identifiant de façon à désigner la cellule correspondante, par exemple la cellule CM1. Les moyens de lecture vont alors extraire de la cellule CM1 les ensembles de bits B0 et B1 qui seront stockés dans les registres à décalage RG1 et RG2. Le multiplexeur MUX est alors commandé par le bit de poids faible CHC0 de l'identifiant IDA du caractère. En d'autres termes, les moyens de lecture confèrent au signal de commande SEL la valeur du mot de sélection MS (bit de poids faible CHC0) de façon à sélectionner, dans le cas présent, les bits stockés dans le registre à décalage RG1.

Supposons maintenant que la mémoire MM ne comporte que des caractères de deuxième format, c'est-à-dire des caractères 18x26. Puisque chaque cellule-mémoire ne comporte que deux ensembles de 9x13 bits, les 2ⁿ (ici 2²) ensembles de bits formant chaque caractère 18x26 devront être stockés dans deux cellules-mémoire différentes. Et, selon l'invention, ces 2ⁿ ensembles de bits sont stockés dans des emplacements consécutifs de la mémoire, c'est-à-dire en l'espèce dans deux cellules-mémoire d'adresses consécutives.

Plus précisément, le caractère de deuxième format, dont l'identifiant IDB est celui de la figure 4, sera réparti dans les deux cellules-mémoire désignées par les deux mots d'adresse-cellule MDCBa et MDCBb (figure 7a et figure 7b) dont les neuf bits de poids forts correspondent aux neuf bits de l'identifiant IDB et dont le bit de poids faible CTL est respectivement égal à zéro et à un. Ces deux cellules-mémoire se situent donc à deux adresses consécutives.

Si l'on se réfère maintenant plus particulièrement à la figure 2, les moyens de commande MC placent les moyens d'adressage et de lecture dans leur deuxième état (DFM = 1). Les moyens d'adressage élaborent alors les deux mots d'adresse MDCBa et MDCBb. Ces deux mots d'adresse sont donc formés par les bits de l'identifiant IDB du caractère CB complétés à droite par un mot de contrôle de CTL de k bits (k=1 ici) permettant de désigner des adresses successives. Par ailleurs, les moyens de lecture confèrent à la valeur SEL la valeur nulle et extraient de la mémoire MM successivement, les bits des deux ensemble de bits des deux cellules désignées.

Bien entendu, la mémoire MM peut comporter à la fois des caractères de premier format et des caractères de deuxième format, qui ne seront bien évidemment pas stockés dans les mêmes cellules-mémoire.

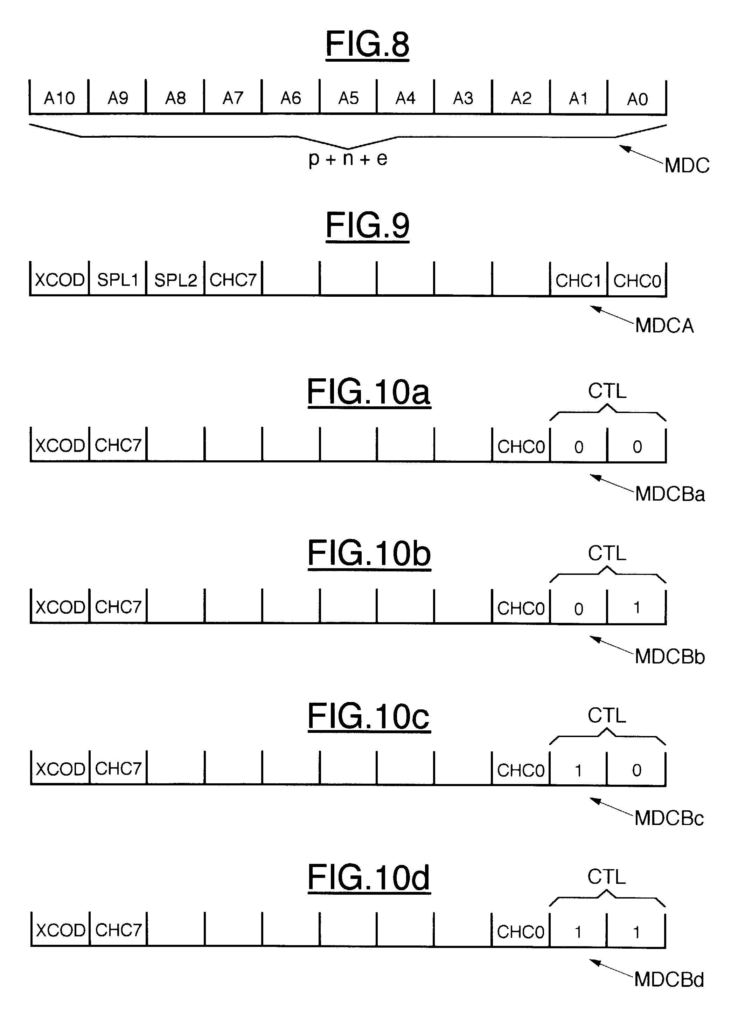

Les figures 8 à 10d illustrent un mode de fonctionnement du dispositif dans lequel k est nul. En d'autres termes, chaque cellule-mémoire CMq ne comporte qu'un seul ensemble de 9x13 bits et est désigné par un mot d'adresse-cellule MDC de p+n+e bits (en l'espèce 11 bits) A0-A10.

Dans ce cas, chaque caractère de premier format sera avantageusement stocké dans la cellule-mémoire dont le mot d'adresse -cellule MDCA (figure 9) correspond à l'identifiant IDA de ce caractère. Ainsi, pour la lecture d'un caractère, les moyens d'adressage vont alors physiquement pointer la mémoire sur la cellule dont l'adresse correspond à l'identifiant.

En ce qui concerne un caractère de deuxième format (18x26), les quatre ensembles de 9x13 bits formant ce caractère seront stockés dans quatre cellules d'adresses consécutives respectivement désigné par les mots d'adresse-cellule MDCBa-MDCBd (figure 10a - figure 10d). Les neuf bits de poids forts de chacun de ces quatre mots d'adresse-cellule seront égaux aux neuf bits de l'identifiant du deuxième caractère. Les deux bits de poids faibles (mot de contrôle CTL) seront alternativement égaux à zéro et un de façon à former quatre adresses consécutives. Pour l'extraction d'un tel caractère, les moyens d'adressage vont successivement pointer la mémoire avec les quatre mots d'adresse-cellule ainsi formés de façon à extraire successivement les quatre ensembles de bits formant ce caractère et permettant, par combinaison, de le représenter.

Ainsi, dans ce mode de réalisation, si la mémoire ne contient que des caractères de premier format (9x13) les caractères identifiés par les identifiants de valeurs décimales 0 1 2 3 4 5 6 7 8 9 10... seront respectivement stockées dans les cellules-mémoire d'adresses 0 1 2 3 4 5 6 7 8 9 10... (en notation décimale).

Si la mémoire ne contient que des caractères de deuxième format (18x26), les caractères identifiés par les identifiants 0;1;2;3, seront respectivement stockés dans les cellules d'adresses 0 1 2 3; 4 5 6 7; 8 9 10 11; et 12 13 14 15 (en notation décimales).

En d'autres termes, dans ce cas, les caractères de deuxième format sont stockés à des adresses multiples de 2ⁿ (ici de quatre 2²) de la mémoire.

Si la mémoire contient à la fois les caractères de premier format et deuxième format, on peut par exemple concevoir que les caractères de premier format ayant comme identifiants 0, 1, 2, 3, 8, 9, 10 soient respectivement stockés dans les cellules-mémoire d'adresses 0, 1, 2, 3, 8, 9, 10 tandis que le caractère de deuxième format ayant pour identifiant 1, soit stocké dans les cellules-mémoire d'adresses 4 5 6 et 7.

L'homme du métier remarque donc notamment sur cet exemple de réalisation, que l'invention permet un stockage optimum de la mémoire, c'est-à-dire sans "trous" et ce quel que soit le mode de fonctionnement utilisé (mode 9x13 ou mode 18x26). L'absence de discontinuité dans l'adressage de la mémoire, demeure même si le nombre de caractères à stocker augmente, c'est-à-dire si le nombre de bits d'extension d'adresse XCOD augmente.

Enfin, l'invention permet un adressage de la mémoire en mode 9x13 pour tous les caractères, en mode 18x26 pour tous les caractères, ou en mode mixte, c'est-à-dire dans lequel il est possible d'un caractère à l'autre de changer de format, et ce, sans modification de la structure logicielle et matérielle des moyens d'adressage et de lecture.

## Revendications

1. Procédé de stockage d'informations de formats différents dans une mémoire, lesdites informations comportant des premières informations (CA) d'un premier format représentées chacune sur un premier nombre de bits et identifiées chacune par un premier identifiant (IDA) codé sur p+n+e bits, p et n étant des entiers strictement positifs et e étant un entier positif ou nul, et/ou des deuxièmes informations (CB) d'un deuxième format représentées chacune sur un deuxième nombre de bits supérieur ou égal au produit du premier nombre par 2ⁿ et identifiées chacune par un deuxième identifiant (IDB) codé sur p+e bits, ladite mémoire comportant des cellules-mémoire (CN) aptes chacune à contenir 2^{k} ensembles de bits et à être désignée par un mot d'adresse-cellule (NDC) de p+n-k+e bits, k étant un entier supérieur ou égal à 0 et inférieur ou égal à n, le nombre de bits de chaque ensemble de bits étant au moins égal audit premier nombre, procédé dans lequel, si k est nul, on stocke chaque première information (CA) dans la cellule-mémoire désignée par un mot d'adresse-cellule dont les bits correspondent aux p+n+e bits de l'identifiant de la première information, et si k est non nul on stocke chaque première information dans une partie de la cellule-mémoire désignée par un mot d'adresse-cellule dont les bits correspondent aux p+n+e-k bits de poids forts de l'identifiant de la première information, partie que l'on sélectionne parmi les 2^{k} ensembles de bits contenus dans cette cellule-mémoire désignée, à l'aide d'un mot de sélection (MS) de k bits correspondant aux k bits de poids faibles de l'identifiant de cette première information, et dans lequel, si k est égal à n, on stocke les 2ⁿ ensembles de bits formant chaque deuxième information (CB) dans la cellule-mémoire désignée par un mot d'adresse-cellule dont les e+p bits correspondent aux e+p bits de l'identifiant de cette deuxième information, et, si k est différent de n, on stocke les 2ⁿ ensembles de bits formant chaque deuxième information dans les 2^{n-k} cellules-mémoire d'adresses consécutives désignées par 2^{n-k} mots d'adresse-cellule dont les e+p bits de poids forts correspondent aux e+p bits de l'identifiant de cette deuxième information.

2. Dispositif de stockage et de lecture d'informations de formats différents, dans lequel lesdites informations peuvent comporter des premières informations d'un premier format représentées chacune sur un premier nombre de bits et identifiées chacune par un premier identifiant codé sur p+n+e bits, p et n étant des entiers strictement positifs et e étant un entier positif ou nul, et/ou des deuxièmes informations d'un deuxième format représentées chacune sur un deuxième nombre de bits supérieur ou égal au produit du premier nombre par 2ⁿ et identifiées chacune par un deuxième identifiant codé sur p+e bits, comprenant
une mémoire (MM) comportant des cellules-mémoire (CM) aptes chacune à contenir 2^{k} ensembles de bits, et à être désignée par un mot d'adresse-cellule de p+n-k+e bits, k étant un entier supérieur ou égal à 0 et inférieur ou égal à n, le nombre de bits de chaque ensemble de bits étant au moins égal audit premier nombre,
des moyens d'adressage (MM) possédant un premier état dans lequel pour chaque première information ils sont aptes à élaborer, si k est nul, un mot d'adresse-cellule (MDC) dont les bits correspondent aux p+n+e bits de l'identifiant de la première information et, si k est non nul, un mot d'adresse-cellule dont les bits correspondent aux p+n+e-k bits de poids forts de l'identifiant de la première information, ainsi qu'un mot de sélection (MS) de k bits correspondant aux k bits de poids faibles de l'identifiant de cette première information, et un deuxième état dans lequel pour chaque deuxième information, ils sont aptes à élaborer, si k est égal à n, un mot d'adresse-cellule dont les e+p bits correspondent aux e+p bits de l'identifiant de cette deuxième information, et, si k est différent de n, 2^{n-k} mots d'adresse-cellule dont les e+p bits de poids forts correspondent aux e+p bits de l'identifiant de cette deuxième information,
des moyens de lecture (MT, DL, RG1, RG2) possédant un premier état dans lequel, pour chaque mot d'adresse-cellule élaboré, ils extraient de la mémoire l'ensemble de bits stocké dans la cellule-mémoire désignée par ledit mot d'adresse-cellule, et éventuellement sélectionné si k est non nul, en fonction des valeurs des k bits du mot de sélection (MS), parmi les 2^{k} ensembles de bits de ladite cellule-mémoire désignée, et un deuxième état dans lequel pour chaque mot d'adresse-cellule élaboré ils extraient, si k est égal à n, les 2ⁿ ensembles de bits stockés dans la cellule-mémoire désignée par le mot d'adresse-cellule, et si k est différent de n, les 2ⁿ ensembles de bits stockés dans les 2^{n-k} cellules-mémoire d'adresses consécutives désignées par les 2^{n-k} mots d'adresse-cellule,
et des moyens de commande (MC) pour mettre les moyens d'adressage et de lecture dans leur premier ou dans leur deuxième état en fonction du format de l'information (DFM = 0; DFM = 1).

3. Dispositif selon la revendication 2, caractérisé par le fait que chaque première information est représentée par une matrice de j lignes de i bits chacune, par le fait que chaque cellule-mémoire comporte un bloc de j paquets de i bits chacun, et par le fait que les moyens d'adressage élaborent pour chaque information j mots d'adressage-ligne (AD) à partir du mot d'adressage-cellule correspondant et d'un mot d'en-tête (ET) permettant de désigner sélectivement chacun des j paquets, et par le fait que les moyens de lecture lisent successivement les j paquets de chaque cellule-mémoire désignée.

4. Dispositif selon la revendication 1 ou 2, caractérisé par le fait que les moyens de lecture comportent 2^{k} registres à décalage (RG1, RG2) respectivement reliés à la sortie de données de la mémoire.
